# EUROPEAN PATENT APPLICATION

(11) **EP 4 243 105 A1**
(43) Date of publication of application: **13.09.2023**
(21) Application number: 21889127.3
(22) Date of filing: 29.10.2021
(51) Int. Cl.: H01L 51/50, C09K 11/06

(54) **ORGANIC ELECTROLUMINESCENT ELEMENT**

(30) Priority: 06.11.2020 JP 2020185577
(71) Applicant: Hodogaya Chemical Co., Ltd., Tokyo, 105-0021 (JP); SFC Co., Ltd., Cheongju-si, Chungcheongbuk-do 28122 (KR)
(72) Inventor: SURUGA Kazuyuki, Tokyo 105-0021 (JP); KO Sang-Won, Tokyo 105-0021 (JP); LEE Bong-Hyang, Tokyo 105-0021 (JP); RYU Jung-Ho, Tokyo 105-0021 (JP); YAMAMOTO Takeshi, Tokyo 105-0021 (JP); IZUMIDA Junichi, Tokyo 105-0021 (JP); CHA Soon-Wook, Cheongju-si, Chungcheongbuk-do 28122 (KR); JOO Sung-Hoon, Cheongju-si, Chungcheongbuk-do 28122 (KR); YANG Byung-Sun, Cheongju-si, Chungcheongbuk-do 28122 (KR); KIM Ji-Hwan, Cheongju-si, Chungcheongbuk-do 28122 (KR); SHIN Bong-Ki, Cheongju-si, Chungcheongbuk-do 28122 (KR)
(74) Representative: Müller-Boré & Partner Patentanwälte PartG mbB
(86) International application number: PCT/JP2021/039956
(87) International publication number: WO 2022/097574

(57) **Abstract**

The present invention provides an organic electroluminescent element which sequentially comprises at least a positive electrode, a first hole transport layer, a second hole transport layer, a blue light emitting layer, an electron transport layer and a negative electrode in this order, wherein the second hole transport layer contains an arylamine compound that is represented by general formula (1).

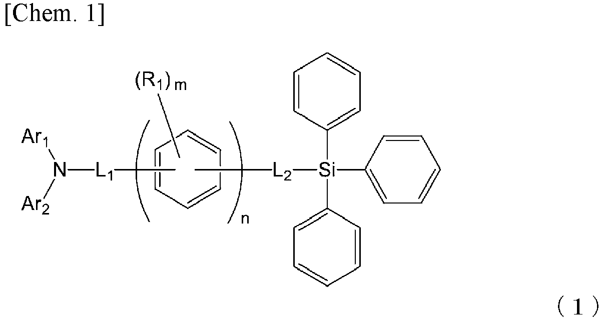

## Description

### TECHNICAL FIELD

The present invention relates to an organic electroluminescent element which is a self-luminescent element suitable for various display devices, and more particularly, to an organic electroluminescent element using a specific arylamine compound (hereinafter abbreviated as an "organic EL element").

### BACKGROUND ART

Since organic EL elements are self-luminescent elements, they are bright and excellent in visibility as compared with liquid crystal elements and capable of giving clear display. Therefore, organic EL elements have been actively studied.

In 1987, C. W. Tang et al. of Eastman Kodak Company put an organic EL element using organic materials into practical use by developing an element having a laminated structure in which various roles are assigned to respective materials. They formed a lamination of a fluorescent material capable of transporting electrons and an organic material capable of transporting holes, so that both charges are injected into the layer of the fluorescent material to emit light, thereby achieving a high luminance of 1,000 cd/m² or more at a voltage of 10 V or lower (see, e.g., Patent Literatures 1 and 2).

To date, many improvements have been performed for practical utilization of the organic EL elements, and high efficiency and durability have been achieved by an electroluminescence element in which an anode, a hole injection layer, a hole transport layer, a light emitting layer, an electron transport layer, an electron injection layer, and a cathode are sequentially provided on a substrate, to further subdivide various roles of the laminated structure (see, e.g., Non-Patent Literature 1).

Moreover, for the purpose of further improvements of luminous efficiency, utilization of triplet exciton has been attempted and utilization of a phosphorescent compound has been investigated (see, e.g., Non-Patent Literature 2). An element that utilizes light emission by thermally activated delayed fluorescence (TADF) has also been developed. In 2011, Adachi et al. of Kyushu University achieved an external quantum efficiency of 5.3% through an element using a thermally activated delayed fluorescence material (see, e.g., Non-Patent Literature 3).

The light emitting layer can be also prepared by doping a charge-transporting compound, generally called a host material, with a fluorescent compound, a phosphorescent compound, or a material emitting delayed fluorescence. The choice of the organic materials in organic EL elements remarkably affects various characteristics such as efficiency and durability of the elements as described in the above-mentioned Non-Patent Literatures (see, e.g., Non-Patent Literatures 1 to 3).

In the organic EL elements, the charges injected from both electrodes are recombined in the light emitting layer to attain light emission, and it is important to efficiently transfer both charges of holes and electrons to the light emitting layer, and it is necessary to obtain an element excellent in carrier balance. In addition, high luminous efficiency can be obtained by enhancing a hole-injection property and enhancing an electron-blocking property of blocking electrons injected from the cathode, to increase the probability of recombination of holes and electrons, and further, by confining excitons generated in the light emitting layer. Therefore, the roles played by the hole-transporting material are important, and there is a demand for a hole-transporting material which has a high hole-injection property, high hole-mobility, a high electron-blocking property, and high durability for electrons.

Heat resistance and amorphous property of the material are also important in terms of the element lifetime. In the case of a material having low heat resistance, thermal decomposition occurs even at a low temperature due to heat generated during driving of the element, and the material is deteriorated. In the case of a material having a low amorphous property, crystallization of the thin film occurs even in a short period, and the element is deteriorated. Therefore, the material used is required to have high heat resistance and a good amorphous property.

As the hole-transporting material used for the organic EL element, N,N'-diphenyl-N,N'-di(α-naphthyl)benzidine (NPD) and various aromatic amine derivatives have been known (see, e.g., Patent Literatures 1 and 2). Although NPD has a good hole-transporting ability, NPD has a glass transition point (Tg), which is an index of heat resistance, as low as 96°C, and thus a deterioration in element characteristics due to crystallization occurs under high-temperature conditions (see, e.g., Non-Patent Literature 4). In addition, among the aromatic amine derivatives described in Patent Literatures, compounds having an excellent mobility as a hole-mobility of 10⁻³ cm²/Vs or more have been known (see, e.g., Patent Literatures 1 and 2). However, these compounds have insufficient electron-blocking property, so that a part of electrons pass through the light emitting layer, and improvements in the luminous efficiency cannot be expected. For higher efficiency, a material which has a higher electron-blocking property, can form a more stable thin film and has higher heat resistance has been required. Aromatic amine derivatives having high durability have been reported (see, e.g., Patent Literature 3). However, this aromatic amine derivatives have been used as a charge-transporting material used for an electrophotographic photoreceptor, and there has been no example using this aromatic amine derivatives in an organic EL element.

As a compound with improved characteristics such as heat resistance and hole-injection property, arylamine compounds having a substituted carbazole structure have been proposed (see, e.g., Patent Literatures 4 and 5). However, in the case of an element in which these compounds are used for a hole injection layer or a hole transport layer, improvements in heat resistance, luminous efficiency, and the like have been achieved, but it is not yet sufficient, and further lower drive voltage and further higher luminous efficiency are required.

In order to improve element characteristics of an organic EL element and improve yields of element preparation, there is a demand for an element having high luminous efficiency, a low drive voltage, and long lifetime, in which holes and electrons can be recombined at high efficiency through combining materials excellent in an injection or transportation performance of holes and electrons, and in stability and durability of a thin film.

In order to improve the element characteristics of an organic EL element, there is a demand for an element having high efficiency, a low drive voltage, and a long lifetime with a good carrier balance through combining materials excellent in an injection or transportation performance of holes and electrons, and in stability and durability of a thin film.

### CITATION LIST

### PATENT LITERATURE

Patent Literature 1: JP H08-048656A
Patent Literature 2: Japanese Patent No. 3194657
Patent Literature 3: Japanese Patent No. 4943840
Patent Literature 4: JP 2006-151979A
Patent Literature 5: WO 2008/62636
Patent Literature 6: WO 2014/009310

### NON-PATENT LITERATURE

Non-Patent Literature 1: Japan Society of Applied Physics Ninth Workshop Preprint, pp. 55-61 (2001)
Non-Patent Literature 2: Japan Society of Applied Physics Ninth Workshop Preprint, pp. 23-31 (2001)
Non-Patent Literature 3: Appl. Phys. Let., 98, 083302 (2011)
Non-Patent Literature 4: Organic EL Debate Third Regular Meeting Preprint, pp. 13-14 (2006)

### SUMMARY OF INVENTION

### TECHNICAL PROBLEM

An object of the present invention is to provide, as a material for an organic EL element having high efficiency and high durability, a hole-transporting material for an organic EL element, which is excellent in the injection or transportation performance of holes, in the electron blocking ability, and in the stability and durability in a state of a thin film. Further, another object is to provide an organic EL element having high efficiency, a low drive voltage, and long lifetime by combining this hole-transporting material with various materials for an organic EL element, which are excellent in the injection or transportation performance of holes and electrons, in the electron blocking ability, in the luminous efficiency, and in the stability and durability in a state of a thin film, such as a blue light-emitting material, so that characteristics of each material can be exhibited effectively.

The physical characteristics to be possessed by an organic compound used as a hole-transporting material that the present invention is to provide can include: (1) good hole injection characteristics; (2) high hole-mobility; (3) an excellent electron blocking ability; (4) a stable state of a thin film; and (5) excellent heat resistance. In addition, the physical characteristics to be possessed by an organic compound used as a blue light-emitting material that the present invention is to provide can include: (1) a high light emission quantum yield in a blue wavelength region (430 nm to 490 nm); (2) excellent stability against oxidation-reduction; (3) a stable state of a thin film; and (4) excellent heat resistance.

The physical characteristics to be possessed by an organic EL element that is to be provided by combining the hole-transporting material and the blue light-emitting material to be provided by the present invention so that the characteristics of these materials can be effectively exhibited can include: (1) high luminous efficiency and high power efficiency; (2) a low light emission starting voltage; (3) a low practical drive voltage; and (4) long lifetime.

### SOLUTION TO PROBLEM

In order to achieve the above objects, the present inventors have focused on the fact that an arylamine compound having a specific structure is excellent in the injection or transport ability of holes, and in the stability and durability of a thin film. They have selected various arylamine compounds to prepare organic EL elements, and have evaluated the characteristics of the elements diligently. As a result, the present inventors have found that in the case where an arylamine compound having a triphenylsilyl group is selected as a material of a second hole transport layer, the holes injected from the anode side can be efficiently transported, and the electron blocking ability is improved. Further, they prepared various organic EL elements by combining the blue light-emitting materials having a specific structure, and evaluated the characteristics of the elements diligently. As a result, they found a combination of a specific arylamine compound and a blue light-emitting material.

An organic electroluminescent element according to an aspect of the present invention that can solve the above problems, includes at least an anode, a first hole transport layer, a second hole transport layer, a blue light-emitting layer, an electron transport layer, and a cathode in this order, in which the second hole transport layer contains an arylamine compound represented by the following general formula (1).

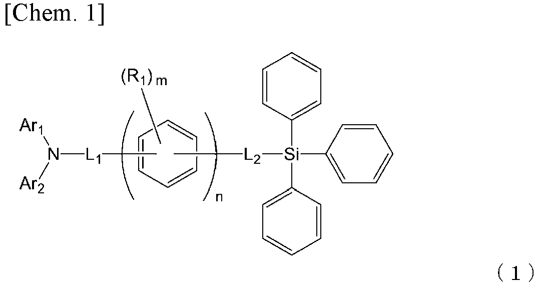

(In the formula, Ar₁ and Ar₂ may be the same as or different from each other, and each represents a substituted or unsubstituted aromatic hydrocarbon group, a substituted or unsubstituted aromatic heterocyclic group, or a substituted or unsubstituted condensed polycyclic aromatic group.

Ar₁ and Ar₂ may be bonded to each other via a single bond, a substituted or unsubstituted methylene group, a substituted or unsubstituted amino group, an oxygen atom, or a sulfur atom, to form a ring.

L₁ and L₂ may be the same as or different from each other, and each represents a divalent group of a substituted or unsubstituted aromatic hydrocarbon, or a divalent group of a substituted or unsubstituted condensed polycyclic aromatic group.

R₁ represents a fluorine atom, a chlorine atom, a trifluoromethyl group, a linear or branched alkyl group having a carbon number of 1 to 6 which may have a substituent, a substituted or unsubstituted aromatic hydrocarbon group, a substituted or unsubstituted aromatic heterocyclic group, or a substituted or unsubstituted condensed polycyclic aromatic group.

m represents an integer of 0 to 4.

n represents an integer of 0 to 2.

In the case where m is an integer of 2 or more, a plurality of R₁'s may be the same as or different from each other, and in the case where n is 2, a plurality of R₁'s bonded to the same benzene ring may be the same as or different from each other.)

In an organic electroluminescent element according to an aspect of the present invention that can solve the above problems, in the above-described organic electroluminescent element, the blue light-emitting layer contains a compound represented by the following general formula (2) or (3) as a blue light-emitting dopant.

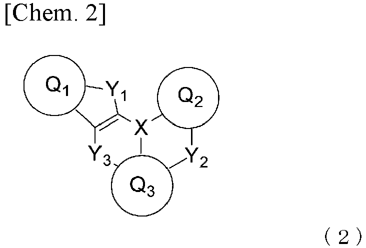

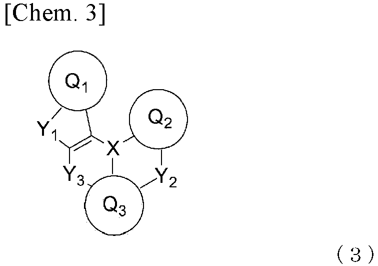

(In the general formulas (2) and (3), Q₁ to Q₃ may be the same as or different from each other, and each represents a substituted or unsubstituted aromatic hydrocarbon, a substituted or unsubstituted condensed polycyclic aromatic group, or a substituted or unsubstituted aromatic heterocycle.

X represents B, P, P=O, or P=S.

Y₁ to Y₃ may be the same as or different from each other, and each represents any one selected from N-R₂, C-R₃R₄, O, S, Se, and Si-R₅R₆.

R₂ to R₆ may be the same as or different from each other, and each represents a hydrogen atom, a deuterium atom, a fluorine atom, a chlorine atom, a cyano group, a nitro group, a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a linear or branched alkyloxy group having a carbon number of 1 to 6 which may have a substituent, a cycloalkyloxy group having a carbon number of 5 to 10 which may have a substituent, a substituted or unsubstituted aromatic hydrocarbon group, a substituted or unsubstituted condensed polycyclic aromatic group, a substituted or unsubstituted aromatic heterocyclic group, or a substituted or unsubstituted aryloxy group.

R₃ and R₄, and R₅ and R₆ may be bonded to each other via a single bond, a substituted or unsubstituted methylene group, an oxygen atom, a sulfur atom, or a monosubstituted amino group, to form a ring.

Here, in the case where Y₁ to Y₃ represent N-R₂, C-R₃R₄, or Si-R₅R₆, R₂ to R₆ may be bonded to adjacent Q₁ to Q₃ via a linking group such as a single bond, a substituted or unsubstituted methylene group, an oxygen atom, a sulfur atom, or a monosubstituted amino group, to form a ring.)

### ADVANTAGEOUS EFFECTS OF INVENTION

The arylamine compound represented by the foregoing general formula (1) according to the present invention has a larger hole-mobility than a hole-transporting material according to the related art, has an excellent electron blocking ability and amorphous property, and forms a stable thin film state. Therefore, in the present invention, the electron-blocking performance of the arylamine compound can be utilized at the maximum when the hole transport layer has a two-layer structure including the first hole transport layer and the second hole transport layer, and the second hole transport layer located on a side adjacent to the light emitting layer is formed from the arylamine compound represented by the foregoing general formula (1).

Further, in the present invention, an organic EL element having a longer lifetime with higher efficiency can be achieved when the blue light-emitting layer of the organic EL element contains the compound represented by the foregoing general formula (2) or (3) as a blue light-emitting dopant.

### BRIEF DESCRIPTION OF DRAWINGS

FIG. 1 is a diagram showing structural formulas of compounds 1-1 to 1-10 as arylamine compounds represented by the general formula (1).
FIG. 2 is a diagram showing structural formulas of compounds 1-11 to 1-18 as arylamine compounds represented by the general formula (1).
FIG. 3 is a diagram showing structural formulas of compounds 1-19 to 1-28 as arylamine compounds represented by the general formula (1).
FIG. 4 is a diagram showing structural formulas of compounds 1-29 to 1-38 as arylamine compounds represented by the general formula (1).
FIG. 5 is a diagram showing structural formulas of compounds 2-1 to 2-11 as compounds represented by the general formula (2).
FIG. 6 is a diagram showing structural formulas of compounds 2-12 to 2-26 as compounds represented by the general formula (2).
FIG. 7 is a diagram showing structural formulas of compounds 3-1 to 3-12 as compounds represented by the general formula (3).
FIG. 8 is a diagram illustrating a configuration of organic EL elements of Examples 6 and 7 and Comparative Examples 1 and 2.

### DESCRIPTION OF EMBODIMENTS

Hereinafter, embodiments of the present invention will be described in detail. First, aspects of the present embodiment will be listed and described.
1) An organic electroluminescent element (organic EL element) including at least an anode, a first hole transport layer, a second hole transport layer, a blue light-emitting layer, an electron transport layer, and a cathode in this order, in which the second hole transport layer contains an arylamine compound represented by the following general formula (1). 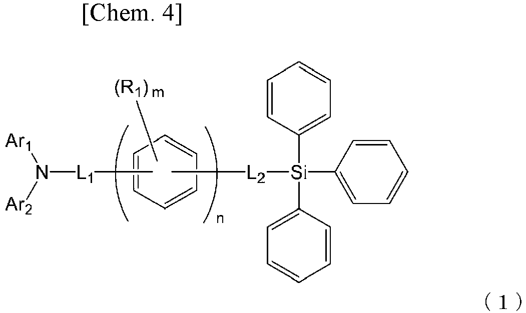 In the formula, Ar₁ and Ar₂ may be the same as or different from each other, and each represents a substituted or unsubstituted aromatic hydrocarbon group, a substituted or unsubstituted aromatic heterocyclic group, or a substituted or unsubstituted condensed polycyclic aromatic group.
   Ar1 and Ar₂ may be bonded to each other via a single bond, a substituted or unsubstituted methylene group, a substituted or unsubstituted amino group, an oxygen atom, or a sulfur atom, to form a ring.
   L₁ and L₂ may be the same as or different from each other, and each represents a divalent group of a substituted or unsubstituted aromatic hydrocarbon, or a divalent group of a substituted or unsubstituted condensed polycyclic aromatic group.
   R₁ represents a fluorine atom, a chlorine atom, a trifluoromethyl group, a linear or branched alkyl group having a carbon number of 1 to 6 which may have a substituent, a substituted or unsubstituted aromatic hydrocarbon group, a substituted or unsubstituted aromatic heterocyclic group, or a substituted or unsubstituted condensed polycyclic aromatic group.
   m represents an integer of 0 to 4.
   n represents an integer of 0 to 2.
   In the case where m is an integer of 2 or more, a plurality of R₁'s may be the same as or different from each other, and in the case where n is 2, a plurality of R₁'s bonded to the same benzene ring may be the same as or different from each other.
2) The organic EL element according to 1), in which L₁ and L₂ in the foregoing general formula (1) each is a substituted or unsubstituted phenylene group.
3) The organic EL element according to 1), in which L₁ and L₂ in the foregoing general formula (1) each is a substituted or unsubstituted 1,4-phenylene group or a substituted or unsubstituted 1,3-phenylene group.
4) The organic EL element according to any one of 1) to 3), in which m in the foregoing general formula (1) is 0.
5) The organic EL element according to any one of 1) to 4), in which the blue light-emitting layer contains, as a blue light-emitting dopant, a pyrene derivative having a pyrene skeleton in a molecule.
6) The organic EL element according to any one of 1) to 4), in which the blue light-emitting layer contains, as a blue light-emitting dopant, a compound represented by the following general formula (2) or (3). 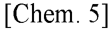 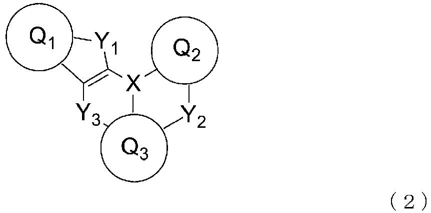 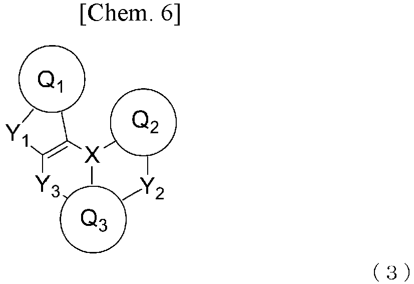 In the general formulas (2) and (3), Q₁ to Q₃ may be the same as or different from each other, and each represents a substituted or unsubstituted aromatic hydrocarbon, a substituted or unsubstituted condensed polycyclic aromatic group, or a substituted or unsubstituted aromatic heterocycle.
   X represents B, P, P=O, or P=S.
   Y₁ to Y₃ may be the same as or different from each other, and each represents any one selected from N-R₂, C-R₃R₄, O, S, Se, and Si-R₅R₆.
   R₂ to R₆ may be the same as or different from each other, and each represents a hydrogen atom, a deuterium atom, a fluorine atom, a chlorine atom, a cyano group, a nitro group, a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a linear or branched alkyloxy group having a carbon number of 1 to 6 which may have a substituent, a cycloalkyloxy group having a carbon number of 5 to 10 which may have a substituent, a substituted or unsubstituted aromatic hydrocarbon group, a substituted or unsubstituted condensed polycyclic aromatic group, a substituted or unsubstituted aromatic heterocyclic group, or a substituted or unsubstituted aryloxy group.
   R₃ and R₄, and R₅ and R₆ may be bonded to each other via a single bond, a substituted or unsubstituted methylene group, an oxygen atom, a sulfur atom, or a monosubstituted amino group, to form a ring.
   Here, in the case where Y₁ to Y₃ represent N-R₂, C-R₃R₄, or Si-R₅R₆, R₂ to R₆ may be bonded to adjacent Q₁ to Q₃ via a linking group such as a single bond, a substituted or unsubstituted methylene group, an oxygen atom, a sulfur atom, or a monosubstituted amino group, to form a ring.
7) The organic EL element according to 6), in which the compound represented by the foregoing general formula (2) or (3) is a compound represented by any one of the following general formulas (4) to (7). 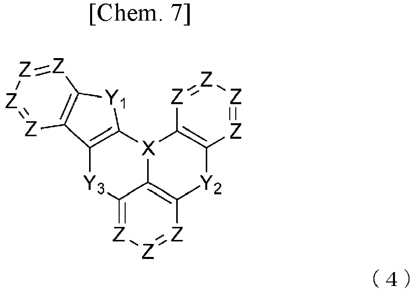 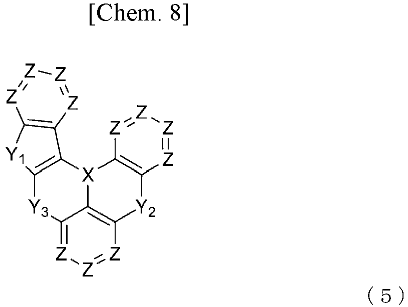 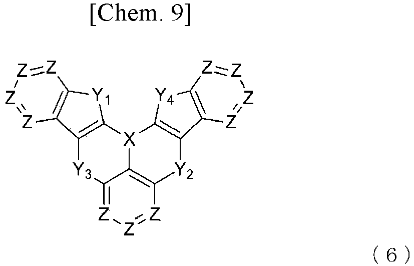 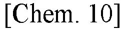 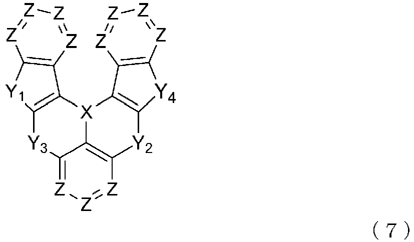 In the general formulas (4) to (7), X, Y₁, Y₂, and Y₃ have the same definitions as those of the foregoing general formulas (2) and (3).
   Y₄ represents any one selected from N-R₂, C-R₃R₄, O, S, Se, and Si-R₅R₆.
   R₂ to R₆ have the same definitions as those of the foregoing general formulas (2) and (3).
   Z's may be the same as or different from each other, and each represents CR₇ or N.
   R₇'s may be the same as or different from each other, and represents a hydrogen atom, a deuterium atom, a halogen group, a cyano group, a nitro group, a linear or branched alkyl group having a carbon number of 1 to 6 which may have a substituent, a cycloalkyl group having a carbon number of 5 to 10 which may have a substituent, a linear or branched alkyloxy group having a carbon number of 1 to 6 which may have a substituent, a linear or branched alkylthioxy group having a carbon number of 1 to 6 which may have a substituent, a linear or branched alkylamine group having a carbon number of 1 to 6 which may have a substituent, a linear or branched alkylsilyl group having a carbon number of 3 to 10 which may have a substituent, a substituted or unsubstituted aromatic hydrocarbon group, a substituted or unsubstituted aromatic heterocyclic group, a substituted or unsubstituted aryloxy group, a substituted or unsubstituted arylthioxy group, a substituted or unsubstituted arylamine group, or a substituted or unsubstituted arylsilyl group.
   R₇ may be bonded to another R₇ or bonded to an adjacent substituent to form an aliphatic or aromatic monocyclic or polycyclic ring, and a carbon atom of the aliphatic or aromatic monocyclic or polycyclic ring can be substituted with one or more heteroatoms selected from N, S and O.

Specific examples of the "linear or branched alkyl group having a carbon number of 1 to 6" in the "linear or branched alkyl group having a carbon number of 1 to 6 which may have a substituent" represented by R₁ in the foregoing general formula (1) include a methyl group, an ethyl group, an n-propyl group, an isopropyl group, an n-butyl group, an isobutyl group, a tert-butyl group, an n-pentyl group, an isopentyl group, a neopentyl group, and an n-hexyl group.

Specific examples of the "substituent" in the "linear or branched alkyl group having a carbon number of 1 to 6 which may have a substituent" represented by R₁ in the general formula (1) include a deuterium atom; a cyano group; a nitro group; a halogen atom such as a fluorine atom, a chlorine atom, a bromine atom, and an iodine atom; a linear or branched alkyloxy group having a carbon number of 1 to 6 such as a methyloxy group, an ethyloxy group, and a propyloxy group; an alkenyl group such as a vinyl group and an allyl group; an aryloxy group such as a phenyloxy group and a tolyloxy group; an arylalkyloxy group such as a benzyloxy group and a phenethyloxy group; an aromatic hydrocarbon group or a condensed polycyclic aromatic group such as a phenyl group, a biphenyl group, a terphenyl group, a naphthyl group, an anthracenyl group, a phenanthryl group, a fluorenyl group, an indenyl group, a pyrenyl group, a perylenyl group, a fluoranthenyl group, and a triphenylenyl group; an aromatic heterocyclic group such as a pyridyl group, a pyrimidinyl group, a triazinyl group, a thienyl group, a furyl group, a pyrrolyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, and a carborinyl group; a di-substituted amino group substituted with an aromatic hydrocarbon group or a condensed polycyclic aromatic group, such as a diphenylamino group and a dinaphthylamino group; a di-substituted amino group substituted with an aromatic heterocyclic group, such as a dipyridylamino group and a dithienylamino group; a di-substituted amino group substituted with a substituent selected from an aromatic hydrocarbon group, a condensed polycyclic aromatic group, and an aromatic heterocyclic group; and the like. These substituents may be further substituted with the above-exemplified substituents.

Specific examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁, Ar₂, and R₁ in the general formula (1) include a phenyl group, a biphenyl group, a terphenyl group, a naphthyl group, an anthracenyl group, a phenanthryl group, a fluorenyl group, an indenyl group, a pyrenyl group, a perylenyl group, a fluoranthenyl group, a triphenylenyl group, a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, and a carborinyl group, and the like.

In addition, these groups may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

Specific examples of the "aromatic hydrocarbon" or the "condensed polycyclic aromatic group" of the "substituted or unsubstituted aromatic hydrocarbon" or the "substituted or unsubstituted condensed polycyclic aromatic group" in the "divalent group of a substituted or unsubstituted aromatic hydrocarbon" or the "divalent group of a substituted or unsubstituted condensed polycyclic aromatic group" represented by L₁ or L₂ in the foregoing general formula (1) include benzene, biphenyl, terphenyl, naphthalene, anthracene, asenaphthalene, fluorene, phenanthrene, indane, pyrene, triphenylene, and the like.

The "divalent group of a substituted or unsubstituted aromatic hydrocarbon" or the "divalent group of a substituted or unsubstituted condensed polycyclic aromatic group" represented by L₁ or L₂ in the general formula (1) represents a divalent group obtained by removing two hydrogen atoms from the "aromatic hydrocarbon" or the "condensed polycyclic aromatic group". These divalent groups may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

In the general formula (1), Ar₁ and Ar₂ each is preferably a "substituted or unsubstituted aromatic hydrocarbon group" or a "substituted or unsubstituted condensed polycyclic aromatic group", more preferably a phenyl group, a biphenyl group, a terphenyl group, a naphthyl group, a phenanthracenyl group, an anthracenyl group, or a fluorenyl group, which is substituted or unsubstituted, and particularly preferably a phenyl group, a biphenyl group, a naphthyl group, or a phenanthracenyl group, which is substituted or unsubstituted.

In the general formula (1), L₁ and L₂ each is preferably a "divalent group of a substituted or unsubstituted aromatic hydrocarbon", more preferably a substituted or unsubstituted phenylene group, and particularly preferably a substituted or unsubstituted 1,4-phenylene group or a substituted or unsubstituted 1,3-phenylene group.

In the general formula (1), m represents an integer of 0 to 4, preferably 0 or 1, and particularly preferably 0.

Specific examples of the "aromatic hydrocarbon", the "condensed polycyclic aromatic group", or the "aromatic heterocycle" in the "substituted or unsubstituted aromatic hydrocarbon", the "substituted or unsubstituted condensed polycyclic aromatic group", or the "substituted or unsubstituted aromatic heterocycle" represented by Q₁ to Q₃ in the foregoing general formulas (2) and (3) include benzene, naphthalene, anthracene, fluorene, phenanthrene, pyridine, pyrimidine, triazine, pyrrole, furan, thiophene, quinoline, isoquinoline, indene, benzofuran, benzothiophene, indole, indoline, carbazole, carboline, benzoxazole, benzothiazole, quinoxaline, benzimidazole, pyrazole, dibenzofuran, dibenzothiophene, naphthyridine, phenanthroline, acridine, and the like.

In addition, they may have a substituent, and examples of the substituent include the same groups as those exemplified in relation to the "substituent" in the "linear or branched alkyl group having a carbon number of 1 to 6 which may have a substituent" represented by R₁ in the foregoing general formula (1). The substituents may be bonded to each other via a single bond, a substituted or unsubstituted methylene group, an oxygen atom, or a sulfur atom, to form a ring.

X in the foregoing general formulas (2) and (3) represents B, P, P=O, or P=S. B is defined as a boron atom, P is defined as a phosphorus atom, P=O is defined as a phosphorus atom to which an oxygen atom is bonded by a double bond, and P=S is defined as a phosphorus atom to which a sulfur atom is bonded by a double bond. In the case where X represents P=O or P=S, the phosphorus atom is a bonding site with another atom in the general formulas (2) and (3).

Y₁ to Y₃ in the foregoing general formulas (2) and (3) may be the same as or different from each other, and each represents any one selected from N-R₂, C-R₃R₄, O, S, Se, and Si-R₅R₆. N-R₂ is defined as a nitrogen atom having R₂ as a substituent, C-R₃R₄ is defined as a carbon atom having R₃ and R₄ as substituents, O is defined as an oxygen atom, S is defined as a sulfur atom, Se is defined as a selenium atom, and Si-R₅R₆ is defined as a silicon atom having R₅ and R₆ as substituents. In the case where Y₁ to Y₃ represent N-R₂, C-R₃R₄, or Si-R₅R₆, the nitrogen atom, the carbon atom, or the silicon atom is a bonding site with another atom in the general formulas (2) and (3). The definitions of R₂ to R₆ will be further described in detail in the following description.

In the case where Y₁ to Y₃ in the foregoing general formulas (2) and (3) represent N-R₂, C-R₃R₄, or Si-R₅R₆, specific examples of the "linear or branched alkyl group having a carbon number of 1 to 6", the "cycloalkyl group having a carbon number of 5 to 10", or the "linear or branched alkenyl group having a carbon number of 2 to 6" in the "linear or branched alkyl group having a carbon number of 1 to 6 which may have a substituent", the "cycloalkyl group having a carbon number of 5 to 10 which may have a substituent", or the "linear or branched alkenyl group having a carbon number of 2 to 6 which may have a substituent" represented by R₂ to R₆ include a methyl group, an ethyl group, an n-propyl group, an isopropyl group, an n-butyl group, an isobutyl group, a tert-butyl group, an n-pentyl group, an isopentyl group, a neopentyl group, an n-hexyl group, a cyclopentyl group, a cyclohexyl group, a 1-adamantyl group, a 2-adamantyl group, a vinyl group, an allyl group, an isopropenyl group, a 2-butenyl group, and the like. In addition, they may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

In the case where Y₁ to Y₃ in the foregoing general formulas (2) and (3) represent N-R₂, C-R₃R₄, or Si-R₅R₆, specific examples of the "linear or branched alkyloxy group having a carbon number of 1 to 6" or the "cycloalkyloxy group having a carbon number of 5 to 10" in the "linear or branched alkyloxy group having a carbon number of 1 to 6 which may have a substituent", or the "cycloalkyloxy group having a carbon number of 5 to 10 which may have a substituent" represented by R₂ to R₆ include a methyloxy group, an ethyloxy group, an n-propyloxy group, an isopropyloxy group, an n-butyloxy group, a tert-butyloxy group, an n-pentyloxy group, an n-hexyloxy group, a cyclopentyloxy group, a cyclohexyloxy group, a cycloheptyloxy group, a cyclooctyloxy group, a 1-adamantyloxy group, a 2-adamantyloxy group, and the like.

In addition, these groups may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

In the case where Y₁ to Y₃ in the foregoing general formulas (2) and (3) represent N-R₂, C-R₃R₄, or Si-R₅R₆, specific examples of the "aromatic hydrocarbon group", the "condensed polycyclic aromatic group", or the "aromatic heterocyclic group" in the "substituted or unsubstituted aromatic hydrocarbon group", the "substituted or unsubstituted condensed polycyclic aromatic group", or the "substituted or unsubstituted aromatic heterocyclic group" represented by R₂ to R₆ include a phenyl group, a biphenyl group, a terphenyl group, a naphthyl group, an anthracenyl group, a phenanthryl group, a pyridyl group, a pyrimidinyl group, a triazinyl group, a furyl group, a pyrrolyl group, a thienyl group, and the like. In addition, these groups may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

In the case where Y₁ to Y₃ in the foregoing general formulas (2) and (3) represent N-R₂, C-R₃R₄, or Si-R₅R₆, specific examples of the "aryloxy group" in the "substituted or unsubstituted aryloxy group" represented by R₂ to R₆ include a phenyloxy group, a biphenylyloxy group, a terphenyloxy group, a naphthyloxy group, an anthracenyloxy group, a phenanthrenyloxy group, a fluorenyloxy group, an indenyloxy group, a pyrenyloxy group, a perylenyloxy group, and the like. In addition, these groups may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

In the foregoing general formulas (2) and (3), the "aromatic hydrocarbon" or the "aromatic heterocycle" in the "substituted or unsubstituted aromatic hydrocarbon" or the "substituted or unsubstituted aromatic heterocycle" represented by Q₁ to Q₃ is preferably benzene, naphthalene, phenanthrene, pyridine, pyrimidine, indene, benzofuran, benzothiophene, or indole, and more preferably benzene or naphthalene.

In the foregoing general formulas (2) and (3), Y₁ preferably represents N-R₂, O, or S, and more preferably represents O or S. In the foregoing general formulas (2) and (3), it is preferable that at least one of Y₂ and Y₃ represents N-R₂, and more preferable that both of Y₂ and Y₃ represent N-R₂. R₂ preferably represents a "substituted or unsubstituted aromatic hydrocarbon group" or a "substituted or unsubstituted condensed polycyclic aromatic group", and more preferably a phenyl group, a biphenyl group, a terphenyl group, or a naphthyl group which is substituted or unsubstituted. X in the foregoing general formulas (2) and (3) may be B.

The compound represented by the foregoing general formulas (2) and (3) may be a compound having a skeleton structure represented by any one of the following general formulas (4) to (7).

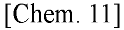

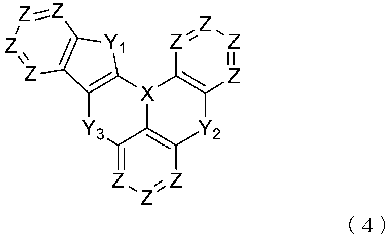

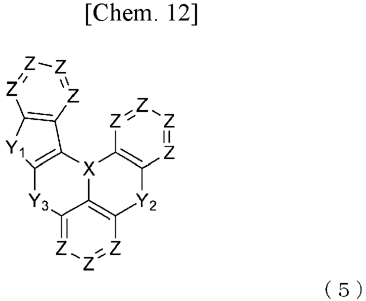

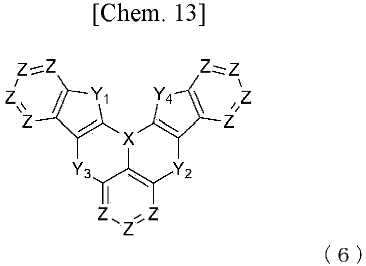

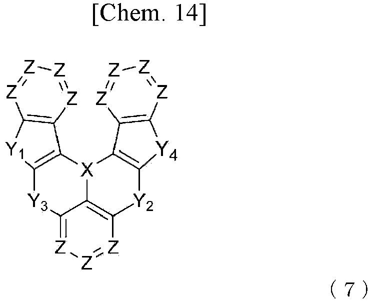

In the general formulas (4) to (7), X, Y₁, Y₂, and Y₃ have the same meaning as those of the foregoing general formulas (2) and (3).
Y₄ represents any one selected from N-R₂, C-R₃R₄, O, S, Se, and Si-R₅R₆.
R₂ to R₆ have the same definitions as those of the foregoing general formulas (2) and (3).
Z's may be the same as or different from each other, and each represents CR₇ or N.
R₇'s may be the same as or different from each other, and represents a hydrogen atom, a deuterium atom, a halogen group, a cyano group, a nitro group, a linear or branched alkyl group having a carbon number of 1 to 6 which may have a substituent, a cycloalkyl group having a carbon number of 5 to 10 which may have a substituent, a linear or branched alkyloxy group having a carbon number of 1 to 6 which may have a substituent, a linear or branched alkylthioxy group having a carbon number of 1 to 6 which may have a substituent, a linear or branched alkylamine group having a carbon number of 1 to 6 which may have a substituent, a linear or branched alkylsilyl group having a carbon number of 3 to 10 which may have a substituent, a substituted or unsubstituted aromatic hydrocarbon group, a substituted or unsubstituted aromatic heterocyclic group, a substituted or unsubstituted aryloxy group, a substituted or unsubstituted arylthioxy group, a substituted or unsubstituted arylamine group, or a substituted or unsubstituted arylsilyl group.

In addition, R₇ may be bonded to another R₇ or bonded to an adjacent substituent to form an aliphatic or aromatic monocyclic or polycyclic ring, and a carbon atom of the aliphatic or aromatic monocyclic or polycyclic ring can be substituted with one or more heteroatoms selected from N, S and O.

Specific examples of the "linear or branched alkyl group having a carbon number of 1 to 6", or the "cycloalkyl group having a carbon number of 5 to 10" in the "linear or branched alkyl group having a carbon number of 1 to 6 which may have a substituent" or the "cycloalkyl group having a carbon number of 5 to 10 which may have a substituent" represented by R₇ in the general formulas (4) to (7) include a methyl group, an ethyl group, an n-propyl group, an isopropyl group, an n-butyl group, an isobutyl group, a tert-butyl group, an n-pentyl group, an isopentyl group, a neopentyl group, an n-hexyl group, a cyclopentyl group, a cyclohexyl group, a 1-adamantyl group, a 2-adamantyl group, and the like. In addition, they may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

Specific examples of the "linear or branched alkyloxy group having a carbon number of 1 to 6" in the "linear or branched alkyloxy group having a carbon number of 1 to 6 which may have a substituent" represented by R₇ in the general formulas (4) to (7) include a methyloxy group, an ethyloxy group, an n-propyloxy group, an isopropyloxy group, an n-butyloxy group, a tert-butyloxy group, an n-pentyloxy group, an n-hexyloxy group, and the like. In addition, these groups may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

Specific examples of the "linear or branched alkylthioxy group having a carbon number of 1 to 6" in the "linear or branched alkylthioxy group having a carbon number of 1 to 6 which may have a substituent" represented by R₇ in the general formulas (4) to (7) include a methylthioxy group, an ethylthioxy group, an n-propylthioxy group, an isopropylthioxy group, an n-butylthioxy group, an isobutylthioxy group, a tert-butylthioxy group, an n-pentylthioxy group, an isopentylthioxy group, a neopentylthioxy group, an n-hexylthioxy group, and the like. In addition, they may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

Specific examples of the "linear or branched alkylamine group having a carbon number of 1 to 6" in the "linear or branched alkylamino group having a carbon number of 1 to 6 which may have a substituent" represented by R₇ in the general formulas (4) to (7) include a methylamine group, an ethylamine group, an n-propylamine group, an isopropylamine group, an n-butylamine group, an isobutylamine group, a tert-butylamine group, an n-pentylamine group, an isopentylamine group, a neopentylamine group, an n-hexylamine group, and the like. In addition, they may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

Specific examples of the "linear or branched alkylsilyl group having a carbon number of 3 to 10" in the "linear or branched alkylsilyl group having a carbon number of 3 to 10 which may have a substituent" represented by R₇ in the general formulas (4) to (7) include a trimethylsilyl group, a triethylsilyl group, a tri-n-propylsilyl group, a triisopropyl silyl group, an n-butyldimethylsilyl group, an isobutyldimethylsilyl group, a tert-butyldimethylsilyl group; and the like. In addition, they may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

Specific examples of the "aromatic hydrocarbon group" or the "aromatic heterocyclic group" in the "substituted or unsubstituted aromatic hydrocarbon group" or the "substituted or unsubstituted aromatic heterocyclic group" represented by R₇ in the general formulas (4) to (7) include a phenyl group, a biphenyl group, a terphenyl group, a naphthyl group, an anthracenyl group, a phenanthryl group, a pyridyl group, a pyrimidinyl group, a triazinyl group, a furyl group, a pyrrolyl group, a thienyl group, and the like. In addition, they may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

Specific examples of the "aryloxy group" in the "substituted or unsubstituted aryloxy group" represented by R₇ in the general formulas (4) to (7) include a phenyloxy group, a biphenylyloxy group, a terphenyloxy group, a naphthyloxy group, an anthracenyloxy group, a phenanthrenyloxy group, a fluorenyloxy group, an indenyloxy group, a pyrenyloxy group, a perylenyloxy group, and the like. In addition, they may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

Specific examples of the "arylthioxy group" in the "substituted or unsubstituted arylthioxy group" represented by R₇ in the general formulas (4) to (7) include a phenylthioxy group, a biphenylthioxy group, a terphenylthioxy group, a naphthylthioxy group, an anthracenylthioxy group, a phenanthrenylthioxy group, a fluorenylthioxy group, an indenylthioxy group, a pyrenylthioxy group, a perylenylthioxy group, and the like. In addition, they may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

Specific examples of the "arylamine group" in the "substituted or unsubstituted arylamine group" represented by R₇ in the general formulas (4) to (7) include a phenylamine group, a biphenylamine group, a terphenylamine group, a naphthylamine group, an anthracenylamine group, a phenanthrenylamine group, a fluorenylamine group, an indenylamine group, a pyrenylamine group, a perylenylamine group, and the like. In addition, they may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

Specific examples of the "arylsilyl group" in the "substituted or unsubstituted arylsilyl group" represented by R₇ in the general formulas (4) to (7) include a triphenylsilyl group, a trinaphthylsilyl group, a terphenylsilyl group, and the like. In addition, they may have a substituent, and examples of the substituent include the same groups as those exemplified in relation to the "substituent" in the "linear or branched alkyl group having a carbon number of 1 to 6 which may have a substituent" represented by R₁ in the foregoing general formula (1).

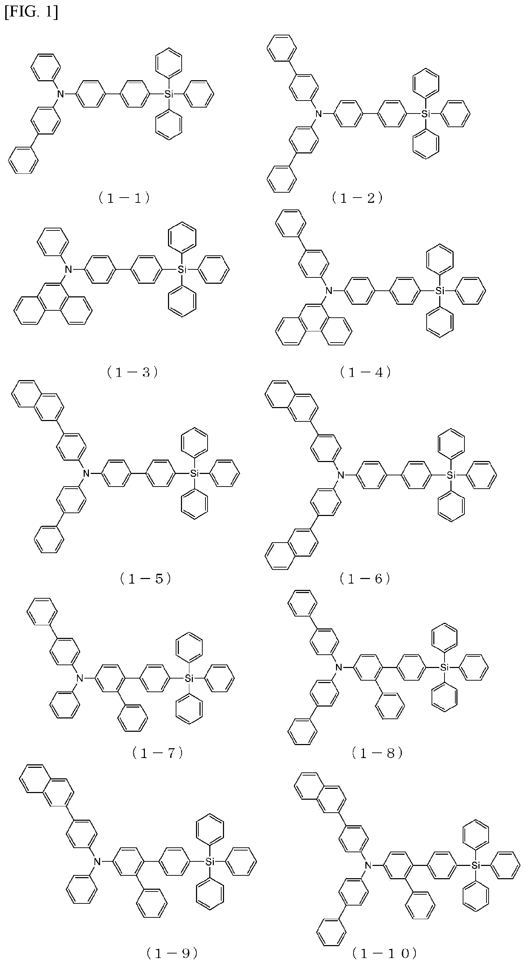

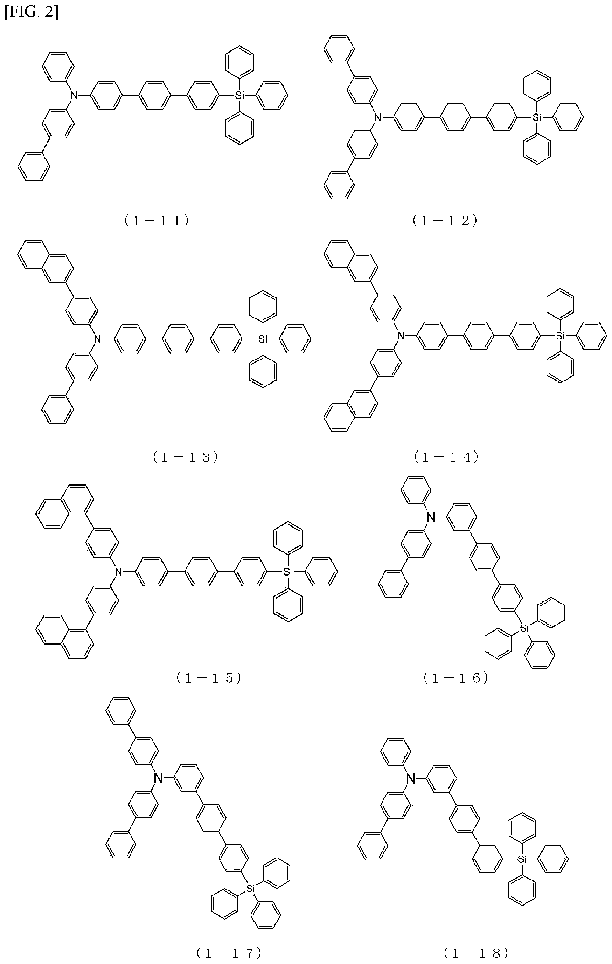

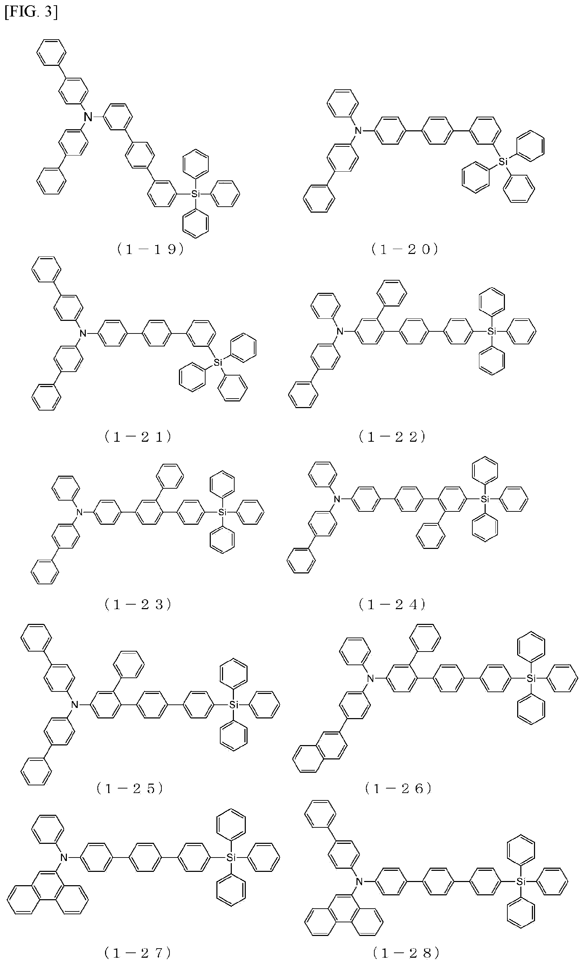

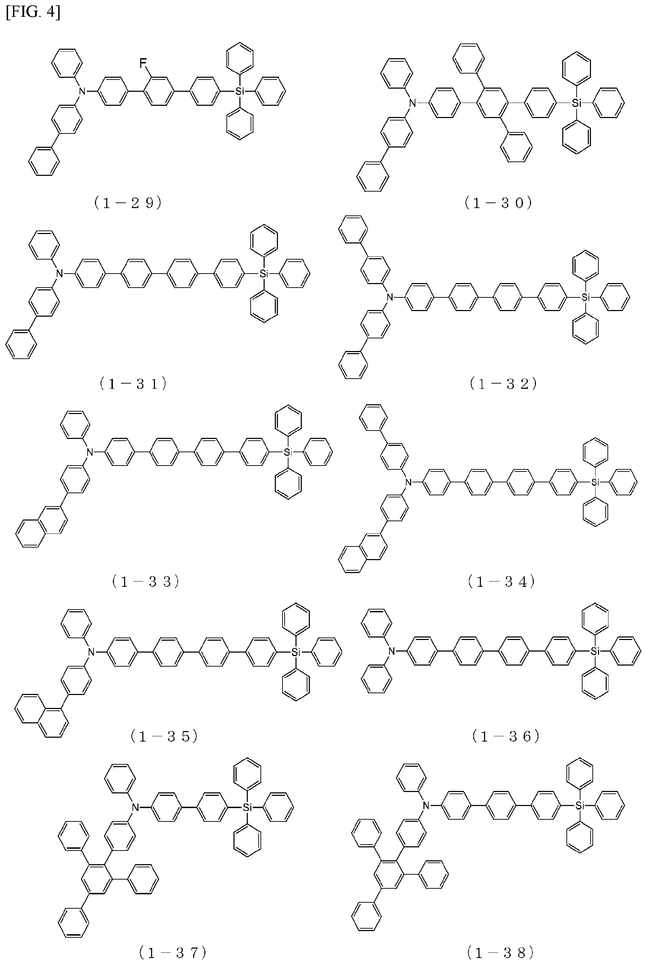

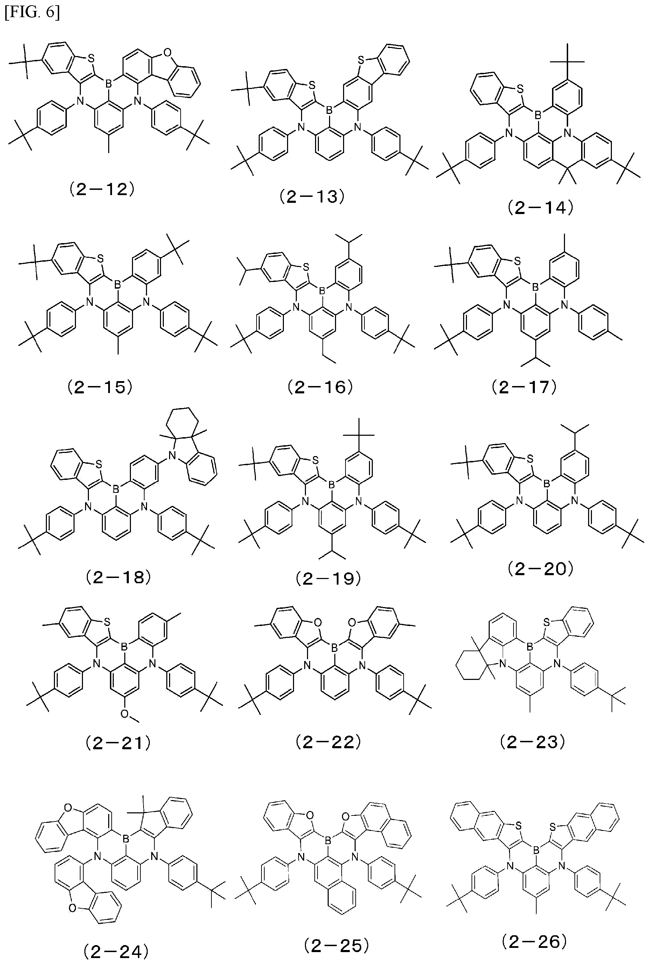

Specific examples of preferred compounds among the arylamine compounds represented by the foregoing general formula (1) preferably used in the organic EL element of the present embodiment are shown in FIGS. 1 to 4, but the present invention is not limited to these compounds.

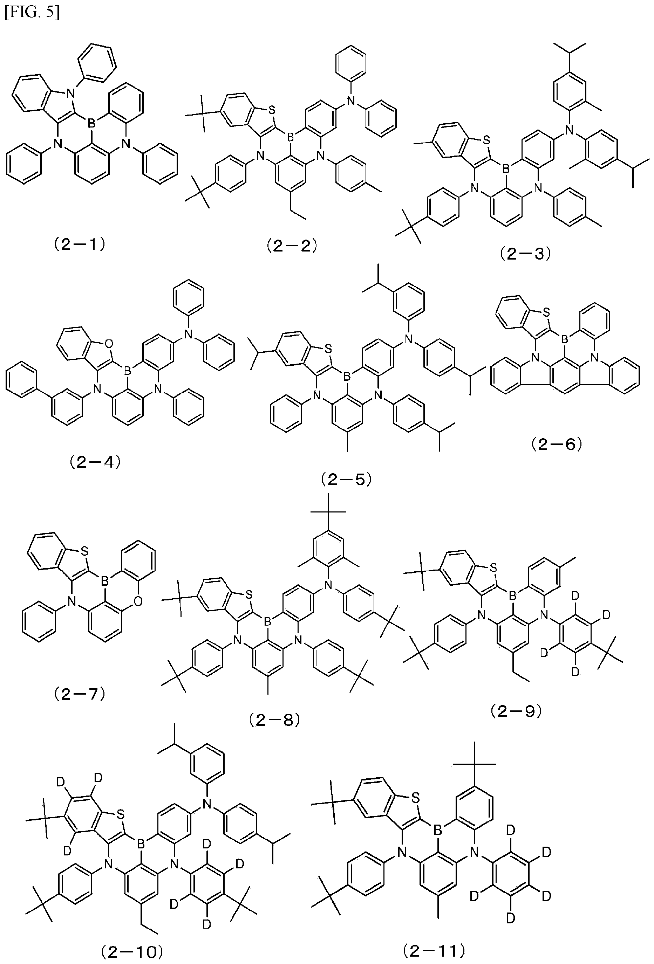

Specific examples of preferred compounds among the compounds represented by the foregoing general formula (2) preferably used in the organic EL element of the present embodiment are shown in FIGS. 5 to 6, but the present invention is not limited to these compounds.

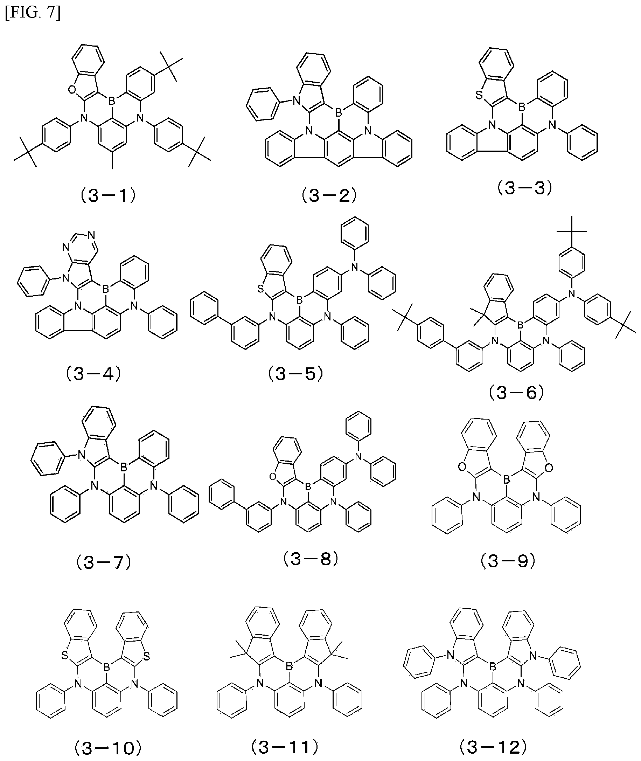

Specific examples of preferred compounds among the compounds represented by the foregoing general formula (3) preferably used in the organic EL element of the present embodiment are shown in FIG. 7, but the present invention is not limited to these compounds.

Purification of the arylamine compounds represented by the general formula (1) may be performed by purification using column chromatography, adsorption purification using silica gel, activated carbon, activated clay, and the like, recrystallization or crystallization using a solvent, sublimation purification, and the like. The compounds may be identified by NMR analysis. As physical property values, a melting point, a glass transition point (Tg), and a work function may be measured. The melting point serves as an index of a vapor deposition property, the glass transition point (Tg) serves as an index of stability of a state of a thin film, and the work function serves as an index of a hole-transporting property or hole-blocking property. In addition, the compound used in the organic EL element of the present embodiment may be a compound purified by purification using column chromatography, adsorption purification using silica gel, activated carbon, activated clay, and the like, recrystallization or crystallization method using a solvent, sublimation purification, or the like, and finally purified by sublimation purification.

The melting point and the glass transition point (Tg) are measured with a high sensitivity differential scanning calorimeter (DSC 3100 SA, manufactured by Bruker AXS GmbH) by using a powder of the compounds. The glass transition point of the compounds represented by the general formula (1) is not particularly limited, and is preferably 80°C or higher, more preferably 100°C or higher, and particularly preferably 110°C or higher, from the viewpoint of stability of the formed thin film. The upper limit of the glass transition point is not particularly limited, and for example, a compound having a glass transition point of 250°C or lower can be used.

The work function is determined by preparing a thin film of 100 nm on an ITO substrate and measuring with an ionization potential measuring device (PYS-202, manufactured by Sumitomo Heavy Industries, Ltd.). The work function of a vapor deposition film having a film thickness of 100 nm that is formed on an ITO substrate by using the compound represented by the general formula (1) is not particularly limited, and is preferably greater than 5.4 eV The upper limit of the work function of the vapor deposition film is not particularly limited, and for example, a vapor deposition film with a work function of 7.0 eV or less may be used.

Examples of the structure of the organic EL element of the present embodiment include a structure having an anode, a hole transport layer, a light emitting layer, an electron transport layer, and a cathode in this order on a substrate, a structure further including a hole injection layer between the anode and the hole transport layer, a structure further including a hole blocking layer between the light emitting layer and the electron transport layer, and a structure further including an electron injection layer between the electron transport layer and the cathode. In these multilayer structures, it is possible to omit or combine several layers of the organic layers, and the structure can have, for example, a configuration in which a hole injection layer and a hole transport layer are combined, a configuration in which an electron injection layer and an electron transport layer are combined, or the like. The structure can have a configuration in which two or more organic layers having the same function are laminated, and the structure can have, for example, a configuration in which two hole transport layers are laminated, a configuration in which two light emitting layers are laminated, a configuration in which two electron transport layers are laminated, or the like. In the structure of the organic EL element of the present embodiment, the hole transport layer has a two-layer structure including the first hole transport layer and the second hole transport layer, and the second hole transport layer in this case is adjacent to the light emitting layer and has a function as an electron blocking layer.

As the anode of the organic EL element of the present embodiment, use can be made of an electrode material having a large work function, such as ITO and gold. As the hole injection layer of the organic EL element of the present embodiment, use can be made of a material such as a starburst triphenyl amine derivative and any of various triphenyl amine tetramer; a porphyrin compound represented by copper phthalocyanine; and a heterocyclic compound having acceptor properties, such as hexacyano azatriphenylene, and a coating polymer material. These materials can be formed into a thin film by a known method such as a spin coating method and an ink jet method in addition to a vapor deposition method.

Examples of the hole transport material that can be used as the first hole transport layer of the organic EL element of the present embodiment include: benzidine derivatives such as N,N'-diphenyl-N,N'-di(m-tolyl)benzidine (TPD), N,N'-diphenyl-N,N'-di(α-naphthyl)benzidine (NPD), and N,N,N',N'-tetrabiphenylylbenzidine; and organic amine compounds such as 1,1-bis[4-(di-4-tolylamino)phenyl]cyclohexane (TAPC) as well as various triphenyl amine derivatives, for example, arylamine compounds having a structure, in which four triphenyl amine structures are linked by a single bond or a divalent group containing no heteroatoms, in its molecule, and arylamine compounds having a structure, in which two triphenyl amine structures are linked by a single bond or a divalent group containing no heteroatoms, in its molecule. These materials may be used to form a film alone, may be used as a single layer formed by being mixed with another material, or may be used in a laminated structure of layers each formed by alone, layers each formed by being mixed with another material, or a layer formed by alone and a layer formed by being mixed with another material. These materials can be formed into a thin film by a known method such as a spin coating method and an ink jet method in addition to a vapor deposition method.

In the hole injection layer or the first hole transport layer, a material obtained by further P-doping trisbromophenylamine hexachloroantimony or a radialene derivative (see, e.g., Patent Literature 6) with a material generally used for the layer, a polymer compound having a structure of a benzidine derivative such as TPD in its partial structure, and the like can be used.

The arylamine compound represented by the foregoing general formula (1) is used as the second hole transport layer located on the light emitting layer side in the organic EL element of the present embodiment. Examples of the hole transport material that may be mixed with or used in combination with the arylamine compound represented by the foregoing general formula (1) include compounds having an electron blocking action, such as carbazole derivatives such as 4,4',4"-tri(N-carbazolyl)triphenylamine (TCTA), 9,9-bis[4-(carbazol-9-yl)phenyl]fluorene, 1,3-bis(carbazol-9-yl)benzene (mCP), and 2,2-bis(4-carbazol-9-ylphenyl)adamantane (Ad-Cz), and compounds having a triphenylsilyl group and a triarylamine structure, which is represented by 9-[4-(carbazol-9-yl)phenyl]-9-[4-(triphenylsilyl)phenyl]-9H-fluorene.

These materials may be used to form a film alone, may be used as a single layer formed by being mixed with another material, or may be used in a laminated structure of layers each formed by alone, layers each formed by being mixed with another material, or a layer formed by alone and a layer formed by being mixed with another material. These materials can be formed into a thin film by a known method such as a spin coating method and an ink jet method in addition to a vapor deposition method.

As the blue light-emitting layer of the organic EL element of the present embodiment, a pyrene derivative having a pyrene skeleton in its molecule, and a compound represented by the foregoing general formula (2) or (3) are preferably used. In addition, any of various metal complexes, an anthracene derivative, a bisstyrylbenzene derivative, an oxazole derivative, and the like can be used. The light emitting layer may be constituted by a host material and a dopant material, and in this case, an anthracene derivative having an anthracene skeleton in its molecule is preferably used as the host material. As the dopant material, a pyrene derivative having a pyrene skeleton in its molecule, and a compound represented by the foregoing general formula (2) or (3) are preferably used. In addition, it is possible to use a heterocyclic compound having an indole ring as a partial structure of a condensed ring, a heterocyclic compound having a carbazole ring as a partial structure of a condensed ring, a carbazole derivative, a benzimidazole derivative, a polydialkylfluorene derivative, a perylene derivative, an indenophenanthrene derivative, and the like. These materials may be used to form a film alone, may be used as a single layer formed by being mixed with another material, or may be used in a laminated structure of layers each formed by alone, layers each formed by being mixed with another material, or a layer formed by alone and a layer formed by being mixed with another material.

A phosphorescence emitter can also be used as the light-emitting material. As the phosphorescence emitter, a phosphorescence emitter of a metal complex of iridium, platinum, or the like can be used. Blue phosphorescence emitter such as FIrpic and FIr6 can be used, and an anthracene derivative having an anthracene skeleton in its molecule is preferably used as the host material in this case. In addition, as a host material having hole injection and transport properties, carbazole derivatives such as 4,4'-di(N-carbazolyl)biphenyl (CBP), TCTA, and mCP, and the like can be used. As the host material having an electron-transporting property, p-bis(triphenyl silyl)benzene (UGH2), 2,2',2"-(1,3,5-phenylene)-tris(1-phenyl-1H-benzimidazole) (TPBI), and the like can be used, and an organic EL element having high performance can be prepared.

In order to avoid concentration quenching, a phosphorescent light-emitting material is preferably doped into the host material in a range of 1 to 30 weight percent(s) relative to the entire light emitting layer, and the doping is preferably performed by co-deposition.

These materials can be formed into a thin film by a known method such as a spin coating method and an inkjet method in addition to a vapor deposition method.

As the hole blocking layer of the organic EL element of the present embodiment, use can be made of a compound having a hole-blocking effect, such as a phenanthroline derivative such as bathocuproine (BCP), a metal complex of a quinolinol derivative such as aluminum (III) bis(2-methyl-8-quinolinate)-4-phenyl phenolate (hereinafter, abbreviated as BAlq), any of various rare earth complexes, a triazole derivative, a triazine derivative, and an oxadiazole derivative. These materials may also double as materials for the electron transport layer. These materials may be used to form a film alone, may be used as a single layer formed by being mixed with another material, or may be used in a laminated structure of layers each formed by alone, layers each formed by being mixed with another material, or a layer formed by alone and a layer formed by being mixed with another material. These materials can be formed into a thin film by a known method such as a spin coating method and an ink jet method in addition to a vapor deposition method.

As the electron transport layer of the organic EL element of the present embodiment, use can be made of a metal complex of a quinolinol derivative including Alq₃ and BAlq, any of various metal complexes, a triazole derivative, a triazine derivative, an oxadiazole derivative, a pyridine derivative, a pyrimidine derivative, a benzimidazole derivative, a thiadiazole derivative, an anthracene derivative, a carbodiimide derivative, a quinoxaline derivative, a pyridoindole derivative, a phenanthroline derivative, a silole derivative, and the like. These materials may be used to form a film alone, may be used as a single layer formed by being mixed with another material, or may be used in a laminated structure of layers each formed by alone, layers each formed by being mixed with another material, or a layer formed by alone and a layer formed by being mixed with another material. These materials can be formed into a thin film by a known method such as a spin coating method and an ink jet method in addition to a vapor deposition method.

As the electron injection layer of the organic EL element of the present embodiment, use can be made of an alkali metal salt such as lithium fluoride and cesium fluoride, an alkaline earth metal salt such as magnesium fluoride, a metal complex of a quinolinol derivative such as lithium quinolinol, a metal oxide such as aluminum oxide, a metal such as ytterbium (Yb), samarium (Sm), calcium (Ca), strontium (Sr), and cesium (Cs), and the like, but this can be omitted in the preferred selection of the electron transport layer and the cathode.

Further, in the electron injection layer or the electron transport layer, a material obtained by further N-doping a metal such as cesium with a material generally used for the layer can be used.

As the cathode of the organic EL element of the present embodiment, an electrode material having a low work function such as aluminum or an alloy having a lower work function such as a magnesium silver alloy, a magnesium indium alloy, or an aluminum magnesium alloy can be used as the electrode material.

### EXAMPLES

The embodiments of the present invention will be described more specifically by Examples below, but the present invention is not limited to the following Examples.

### [Example 1]

### <Synthesis of N-([1,1'-biphenyl]-4-yl)-N-phenyl-4"-(triphenyl silyl)-[1,1':4',1"-terphenyl]-4-amine (1-11)>

To a reaction vessel in which the atmosphere was replaced with nitrogen gas, 30.0 g of 4'-bromo-N-phenyl-[1,1'-biphenyl]-4-amine, 36.9 g of 1-bromo-4-(triphenyl silyl)benzene, 240 mL of toluene, 120 mL of ethanol, and an aqueous solution obtained by dissolving 22.3 g of potassium carbonate in 90 mL of purified water were added, and nitrogen gas was introduced thereto while irradiating the mixture with ultrasonic waves for 30 minutes. Thereto was added 3.7 g of tetrakis(triphenylphosphine)palladium, and the thus-obtained solution was stirred under reflux for 18 hours. After cooling, the reaction liquid was separated, and the thus-obtained organic layer was washed sequentially with 200 mL of city water and 200 mL of saturated saline. The organic layer was dried with anhydrous magnesium sulfate, and the drying agent was removed by filtration. The obtained filtrate was concentrated, and 450 mL of chlorobenzene was added to the residue, followed by heating and stirring. At 80°C, 24 g of silica gel was added thereto, followed by stirring for 1 hour, and the solid was removed by thermal filtration. The obtained filtrate was concentrated, and the residue was recrystallized with chlorobenzene to obtain 38.0 g (yield: 81%) of N-phenyl-4"-(triphenyl silyl)-[1,1':4',1"-terphenyl]-4-amine as a pale yellow powder.

To a reaction vessel in which the atmosphere was replaced with nitrogen gas, 8.5 g of N-phenyl-4"-(triphenyl silyl)-[1,1':4',1"-terphenyl]-4-amine, 3.9 g of 4-bromobiphenyl, 2.1 g of t-butoxy sodium, and 125 mL of toluene were added, and nitrogen gas was introduced thereto while irradiating the mixture with ultrasonic waves for 30 minutes. Thereto were added 0.1 g of palladium acetate and 0.2 g of a 50% toluene solution of t-butyl phosphine, and the thus-obtained solution was heated and stirred under reflux for 3 hours. After cooling the reaction liquid to 80°C, inorganic substances were removed by thermal filtration. The filtrate was heated and stirred, 10 g of silica gel was added thereto at 80°C, followed by stirring for 1 hour, and the solid was removed by thermal filtration. The obtained filtrate was concentrated, and the residue was purified by column chromatography to obtain 7.2 g of (yield: 67%) of N-([1,1'-biphenyl]-4-yl)-N-phenyl-4"-(triphenyl silyl)-[1,1':4',1"-terphenyl]-4-amine (1-11) as a white solid.

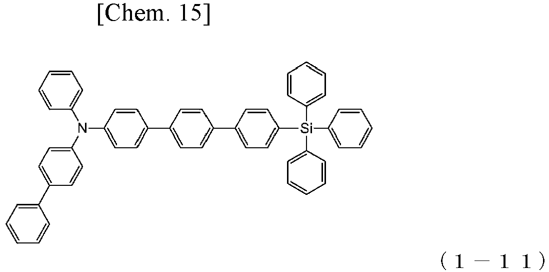

The structure of the obtained white powder was identified by using NMR.

The signals of the following 41 hydrogen atoms were detected with ¹H-NMR(CDCl₃).
δ (ppm) = 7.49-7.70 (20H), 7.35-7.46 (11H), 7.27-7.32 (3H), 7.18-7.21 (6H), 7.04-7.08 (1H).

### [Example 2]

### <Synthesis of N-phenyl-N-(4"-(triphenyl silyl)-[1,1':4',1"-terphenyl)-4-yl)phenanthrene-9-amine (1-27)>

To a reaction vessel in which the atmosphere was replaced with nitrogen gas, 8.5 g of N-phenyl-4"-(triphenyl silyl)-[1,1':4',1"-terphenyl]-4-amine, 4.3 g of 9-bromophenanthrene, 2.1 g of t-butoxy sodium, and 130 mL of toluene were added, and nitrogen gas was introduced thereto while irradiating the mixture with ultrasonic waves for 30 minutes. Thereto were added 0.1 g of palladium acetate and 0.2 g of a 50% toluene solution of t-butyl phosphine, and the thus-obtained solution was heated and stirred under reflux for 3 hours. After cooling the reaction liquid to 80°C, inorganic substances were removed by thermal filtration. The filtrate was heated and stirred, 10 g of silica gel was added thereto at 80°C, followed by stirring for 1 hour, and the solid was removed by thermal filtration. The filtrate was concentrated, and the residue was purified by column chromatography to obtain 6.7 g (yield: 60%) of N-phenyl-N-(4"-(triphenyl silyl)-[1,1':4',1"-terphenyl]-4-yl)phenanthrene-9-amine as a white solid.

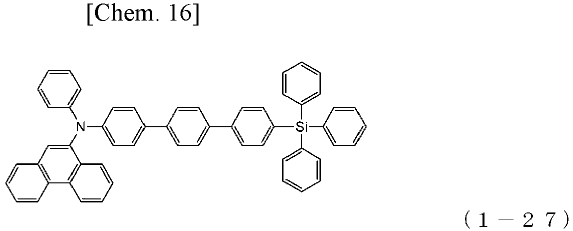

The structure of the obtained white powder was identified by using NMR.

The signals of the following 41 hydrogen atoms were detected with ¹H-NMR(CDCl₃).
δ (ppm) = 8.69-8.75 (2H), 8.06-8.08 (1H), 7.75-7.77 (1H), 7.36-7.65 (30H), 7.13-7.25 (6H), 6.96-6.99 (1H).

### [Example 3]

### <Synthesis of compound (2-11)>

To a reaction vessel, 45.0 g of 1-bromobenzene (D-substituted), 58.0 g of 4-tert-butylaniline, 1.0 g of palladium acetate (II), 30.0 g of tert-butoxy sodium, 2.0 g of bis(diphenylphosphino)-1,1'-binaphthyl, and 450 mL of toluene were added, and the mixture was stirred under reflux for 24 hours. After cooling, the thus-obtained solution was concentrated and purified by column chromatography to obtain 49.9 g (yield: 78%) of the following compound (2-11a) as a powder.

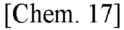

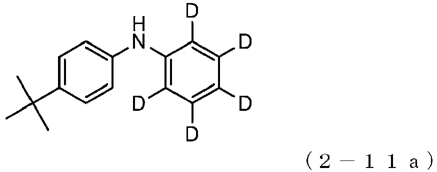

To a reaction vessel, 20.0 g of the above-obtained compound (2-11a), 18.4 g of the following compound (2-11b), 0.5 g of palladium acetate (II), 18.9 g of tert-butoxy sodium, 0.8 g of tri(tert-butyl)phosphine, and 200 mL of toluene were added, and the mixture was stirred under reflux for 24 hours. After cooling, the thus-obtained solution was concentrated and purified by column chromatography to obtain 21.5 g (yield: 84%) of the following compound (2-1 1c) as a powder.

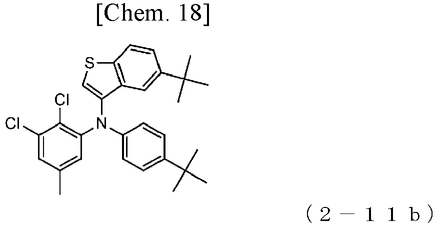

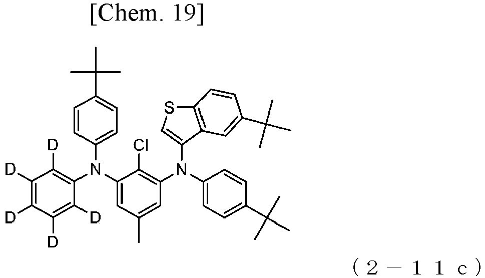

To a reaction vessel, 12.0 g of the above-obtained compound (2-11c) and 120 mL of tert-butylbenzene were added, 42.5 mL of n-butyllithium was added thereto dropwise at - 78°C, and then, nitrogen gas was introduced thereto while stirring the mixture at 60°C for 3 hours. Next, 11.3 g of boron tribromide was added thereto dropwise at -78°C, then stirring was performed at room temperature for 1 hour, 5.9 g of N,N-diisopropylethylamine was further added thereto dropwise at 0°C, and then stirring was performed at 120°C for 2 hours. After cooling, a sodium acetate aqueous solution was added thereto, followed by stirring, and the reaction liquid was extracted with ethyl acetate. The thus-obtained organic layer was concentrated and then was purified with chromatography, thereby obtaining 1.7 g (yield: 11%) of the following compound (2-11) as a powder.

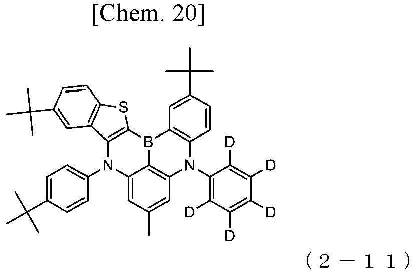

### [Example 4]

The glass transition point of the arylamine compound represented by the general formula (1) was measured with a high sensitivity differential scanning calorimeter (DSC 3100 SA, manufactured by Bruker AXS GmbH).

| | Glass transition point |
|---|---|
| Compound (1-11) of Example 1 | 107°C |
| Compound (1-27) of Example 2 | 128°C |

The arylamine compounds represented by the general formula (1) in Examples 1 and 2 have a glass transition point of 100°C or higher, which indicates exhibiting a stable state of a thin film.

### [Example 5]

Using the arylamine compound represented by the general formula (1) in each of Examples 1 and 2, a vapor deposition film having a film thickness of 100 nm was prepared on an ITO substrate, and the work function was measured by an ionization potential measurement device (PYS-202, manufactured by Sumitomo Heavy Industries, Ltd.).

| | Work function |
|---|---|
| Compound (1-11) of Example 1 | 5.78 eV |
| Compound (1-27) of Example 2 | 5.82 eV |

It can be found that the arylamine compounds represented by the general formula (1) in Examples 1 and 2 exhibit a suitable energy level as compared with a work function of 5.4 eV of the general hole-transporting material such as NPD and TPD, and that they have good hole-transporting ability.

### [Example6]

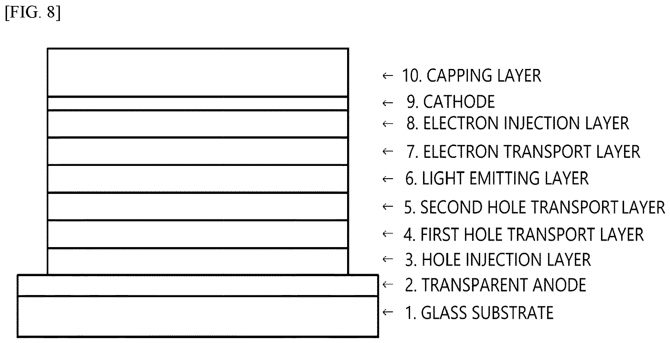

As illustrated in FIG. 8, an organic EL element was prepared by depositing a hole injection layer 3, a first hole transport layer 4, a second hole transport layer 5, a light emitting layer 6, an electron transport layer 7, an electron injection layer 8, a cathode 9, and a capping layer 10 in this order on a glass substrate 1 on which a reflective ITO electrode had been formed as a transparent anode 2 in advance.

Specifically, the glass substrate 1 on which ITO having a film thickness of 50 nm, a silver alloy reflective film having a film thickness of 100 nm, and ITO having a film thickness of 5 nm were sequentially formed was ultrasonically washed in isopropyl alcohol for 20 minutes, and then was dried for 10 minutes on a hot plate heated at 250°C. Thereafter, after performing UV ozone treatment for 15 minutes, the glass substrate with ITO was mounted in a vacuum deposition machine, and followed by evacuating to 0.001 Pa or lower. Subsequently, an electron acceptor (Acceptor-1) having the following structural formula and Compound (HTM-1) having the following structural formula were subjected to binary deposition on the transparent anode 2 at a deposition rate such that a deposition rate ratio of Acceptor-1 : Compound (HTM-1) = 3 : 97. As a result, the hole injection layer 3 to cover the transparent anode 2 was formed so as to have a film thickness of 10 nm. On the hole injection layer 3, the first hole transport layer 4 was formed by using Compound (HTM-1) having the following structural formula so as to have a film thickness of 140 nm. On the first hole transport layer 4, the second hole transport layer 5 was formed by using Compound (1-11) in Example 1 so as to have a film thickness of 5 nm. On the second hole transport layer 5, Compound (2-11) in Example 3 and Compound (EMH-1) having the following structural formula were subjected to binary deposition at a deposition rate such that a deposition rate ratio of Compound (2-11) : Compound (EMH-1) = 5 : 95. As a result, the light emitting layer 6 was formed so as to have a film thickness of 20 nm. On the light emitting layer 6, Compound (ETM-1) having the following structural formula and Compound (ETM-2) having the following structural formula were subjected to binary deposition at a deposition rate such that a deposition rate ratio of Compound (ETM-1) : Compound (ETM-2) = 50 : 50. As a result, the electron transport layer 7 was formed so as to have a film thickness of 30 nm. On the electron transport layer 7, the electron injection layer 8 was formed by using lithium fluoride so as to have a film thickness of 1 nm. On the electron injection layer 8, the cathode 9 was formed by using a magnesium-silver alloy so as to have a film thickness of 12 nm. Finally, the capping layer 10 was formed by using Compound (CPL-1) having the following structural formula so as to have a film thickness of 60 nm. The prepared organic EL element was measured for light emission characteristics when a DC voltage was applied thereto at room temperature in the atmosphere. The results are summarized in Table 1.

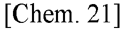

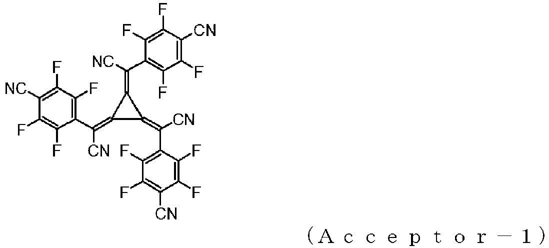

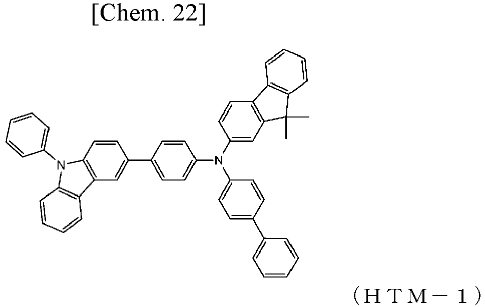

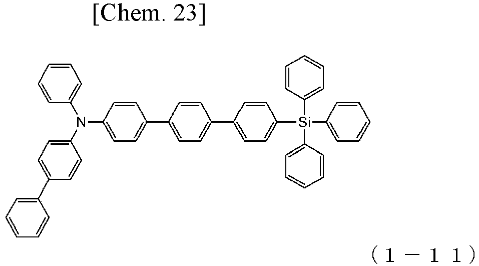

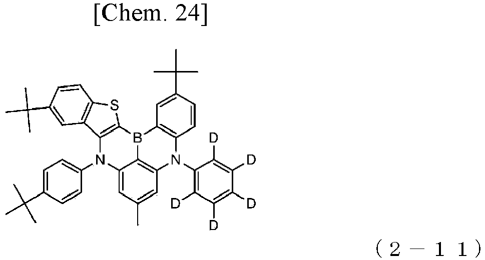

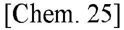

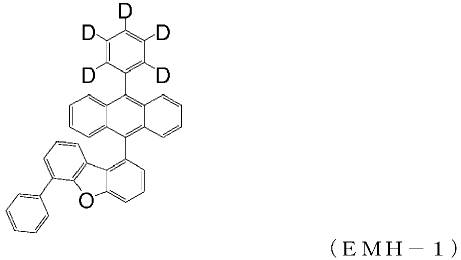

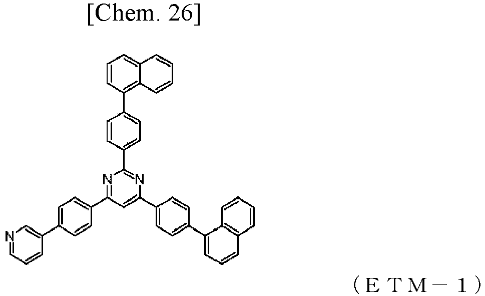

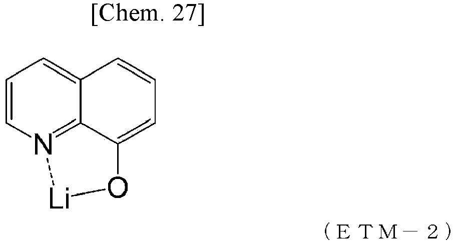

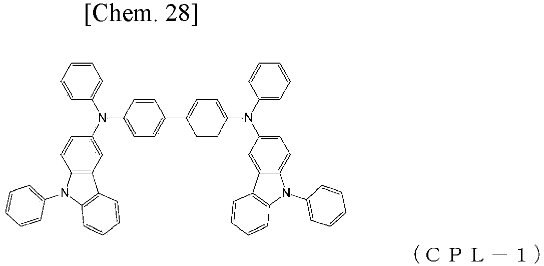

### [Example 7]

An organic EL element was prepared under the same conditions as in Example 6 except that Compound (1-27) in Example 2 was used as a material of the second hole transport layer 5 instead of Compound (1-11) in Example 1. The prepared organic EL element was measured for characteristics at room temperature in the atmosphere. The measurement results of the light emission characteristics when a DC voltage was applied to the prepared organic EL element were summarized in Table 1.

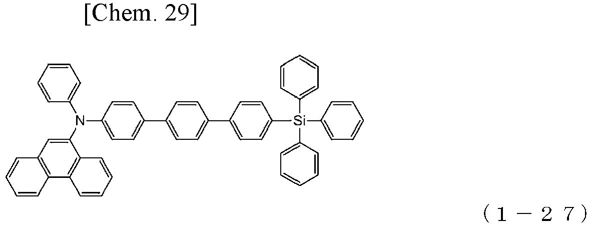

### [Comparative Example 1]

For comparison, an organic EL element was prepared under the same conditions as in Example 6 except that Compound (HTM-2) having the following structural formula was used as a material of the second hole transport layer 5 instead of Compound (1-11) in Example 1. The prepared organic EL element was measured for characteristics at room temperature in the atmosphere. The measurement results of the light emission characteristics when a DC voltage was applied to the prepared organic EL element were summarized in Table 1.

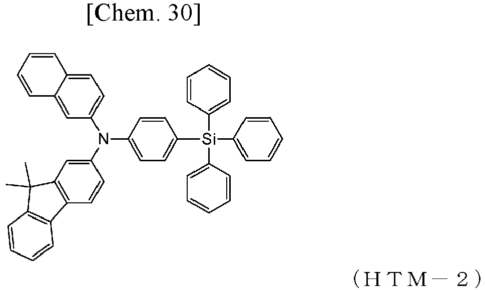

### [Comparative Example 2]

For comparison, an organic EL element was prepared under the same conditions as in Example 6 except that Compound (HTM-3) having the following structural formula was used as a material of the second hole transport layer 5 instead of Compound (1-11) in Example 1. The prepared organic EL element was measured for characteristics at room temperature in the atmosphere. The measurement results of the light emission characteristics when a DC voltage was applied to the prepared organic EL element were summarized in Table 1.

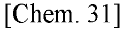

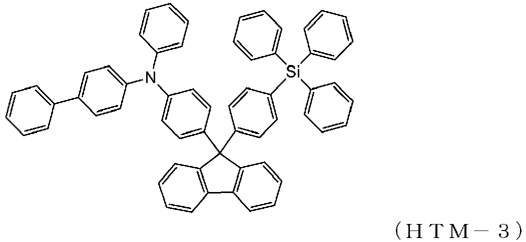

The results of measuring element lifetime of the organic EL elements prepared in Examples 6 and 7 and Comparative Examples 1 and 2 were summarized and shown in Table 1. The element lifetime was measured as time from a time point when emission luminance at the light-emission start (initial luminance) was 2,000 cd/m² and constant-current driving was performed to a time point when the emission luminance attenuated to 1,900 cd/m² (equivalent to 95% of the initial luminance which is set as 100%: 95% attenuation).

**[Table 1]**

| | Second hole transport layer | Voltage [V] (@10 mA/cm²) | Luminance [cd/m²] (@10 mA/cm²) | Luminous efficiency [cd/A] (@10 mA/cm²) | Power efficiency [lm/W] (@10 mA/cm²) | Device lifetime 95% attenuation |
|---|---|---|---|---|---|---|
| Ex. 6 | Compound 1-11 | 3.31 | 1047 | 10.49 | 9.87 | 456 |
| Ex. 7 | Compound 1-27 | 3.34 | 1032 | 10.34 | 9.72 | 383 |
| Comp. Ex. 1 | HTM-2 | 3.41 | 993 | 9.93 | 9.18 | 336 |
| Comp. Ex. 2 | HTM-3 | 3.44 | 968 | 9.69 | 8.96 | 301 |

As shown in Table 1, when a current with a current density of 10 mA/cm² flowed, the luminous efficiency of the organic EL elements in Comparative Examples 1 and 2 was within a range of 9.69 to 9.93 cd/A. In contrast, the luminous efficiency of the organic EL elements in Examples 6 and 7 was within a range of 10.34 to 10.49 cd/A, which both had high luminous efficiency. The power efficiency of the organic EL elements in Comparative Examples 1 and 2 was within a range of 8.96 to 9.18 lm/W. In contrast, the power efficiency of the organic EL elements in Examples 6 and 7 was within a range of 9.72 to 9.87 lm/W, which both had high power efficiency. In addition, the element lifetime (95% attenuation) of the organic EL elements in Comparative Examples 1 and 2 was within a range of 301 to 336 hours. In contrast, the element lifetime of the organic EL elements in Examples 6 and 7 was within a range of 383 to 456 hours, and it is found that lifetime was improved.

As is clear from the above-described results, the arylamine compound having the specific structure, which is represented by the general formula (1), has a large hole-mobility and an excellent electron-blocking ability as compared with the arylamine compound serving as a hole-transporting material in the related art. Further, it was found that the organic EL element using both the second hole transport layer using the arylamine compound and the blue light-emitting layer using the compound represented by the general formula (2) or the general formula (3) as a blue light-emitting dopant can realize an organic EL element having high luminous efficiency and a long lifetime as compared with the organic EL element in the related art.

Although the present invention has been described in detail with reference to specific embodiments, it is apparent to those skilled in the art that various changes and modifications can be made without departing from the spirit and scope of the present invention.

The present application is based on Japanese Patent Application No. 2020-185577 filed on November 6, 2020, the entire contents of which are incorporated herein by reference. All the references cited herein are incorporated as a whole.

### INDUSTRIAL APPLICABILITY

According to the organic EL element of the present invention that uses the arylamine compound having a specific structure, the luminous efficiency can be improved, and the durability of the organic EL element can be improved. For example, the organic EL element can be deployed in a home electric appliance or lighting application.

### REFERENCE SIGNS LIST

- 1: glass substrate
- 2: transparent anode
- 3: hole injection layer
- 4: first hole transport layer
- 5: second hole transport layer
- 6: light emitting layer
- 7: electron transport layer
- 8: electron injection layer
- 9: cathode
- 10: capping layer

## Claims

1. An organic electroluminescent element comprising at least an anode, a first hole transport layer, a second hole transport layer, a blue light-emitting layer, an electron transport layer, and a cathode in this order, wherein the second hole transport layer comprises an arylamine compound represented by the following general formula (1): 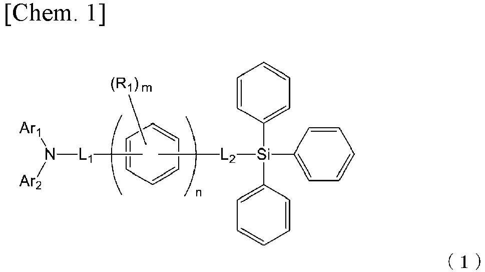
in the formula, Ar₁ and Ar₂ may be the same as or different from each other, and each represents a substituted or unsubstituted aromatic hydrocarbon group, a substituted or unsubstituted aromatic heterocyclic group, or a substituted or unsubstituted condensed polycyclic aromatic group;
Ar₁ and Ar₂ may be bonded to each other via a single bond, a substituted or unsubstituted methylene group, a substituted or unsubstituted amino group, an oxygen atom, or a sulfur atom, to form a ring;
L₁ and L₂ may be the same as or different from each other, and each represents a divalent group of a substituted or unsubstituted aromatic hydrocarbon, or a divalent group of a substituted or unsubstituted condensed polycyclic aromatic group;
R₁ represents a fluorine atom, a chlorine atom, a trifluoromethyl group, a linear or branched alkyl group having a carbon number of 1 to 6 which may have a substituent, a substituted or unsubstituted aromatic hydrocarbon group, a substituted or unsubstituted aromatic heterocyclic group, or a substituted or unsubstituted condensed polycyclic aromatic group;
m represents an integer of 0 to 4;
n represents an integer of 0 to 2; and
in a case where m is an integer of 2 or more, a plurality of R₁'s may be the same as or different from each other, and in a case where n is 2, a plurality of R₁'s bonded to the same benzene ring may be the same as or different from each other.

2. The organic electroluminescent element according to claim 1, wherein L₁ and L₂ in the foregoing general formula (1) each is a substituted or unsubstituted phenylene group.

3. The organic electroluminescent element according to claim 1, wherein L₁ and L₂ in the foregoing general formula (1) each is a substituted or unsubstituted 1,4-phenylene group or a substituted or unsubstituted 1,3-phenylene group.

4. The organic electroluminescent element according to any one of claims 1 to 3, wherein m in the foregoing general formula (1) is 0.

5. The organic electroluminescent element according to any one of claims 1 to 4, wherein the blue light-emitting layer comprises, as a blue light-emitting dopant, a pyrene derivative having a pyrene skeleton in a molecule.

6. The organic electroluminescent element according to any one of claims 1 to 4, wherein the blue light-emitting layer comprises, as a blue light-emitting dopant, a compound represented by the following general formula (2) or (3): 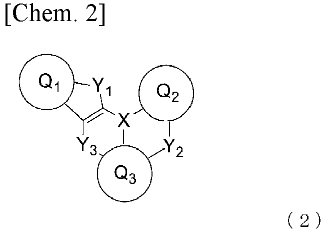 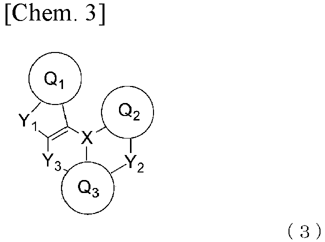
in the formulas (2) and (3), Q₁ to Q₃ may be the same as or different from each other, and each represents a substituted or unsubstituted aromatic hydrocarbon, a substituted or unsubstituted condensed polycyclic aromatic group, or a substituted or unsubstituted aromatic heterocycle;
X represents B, P, P=O, or P=S;
Y₁ to Y₃ may be the same as or different from each other, and each represents any one selected from N-R₂, C-R₃R₄, O, S, Se, and Si-R₅R₆;
R₂ to R₆ may be the same as or different from each other, and each represents a hydrogen atom, a deuterium atom, a fluorine atom, a chlorine atom, a cyano group, a nitro group, a linear or branched alkyl group having a carbon number of 1 to 6 which may have a substituent, a cycloalkyl group having a carbon number of 5 to 10 which may have a substituent, a linear or branched alkenyl group having a carbon number of 2 to 6 which may have a substituent, a linear or branched alkyloxy group having a carbon number of 1 to 6 which may have a substituent, a cycloalkyloxy group having a carbon number of 5 to 10 which may have a substituent, a substituted or unsubstituted aromatic hydrocarbon group, a substituted or unsubstituted condensed polycyclic aromatic group, a substituted or unsubstituted aromatic heterocyclic group, or a substituted or unsubstituted aryloxy group;
R₃ and R₄, and R₅ and R₆ may be bonded to each other via a single bond, a substituted or unsubstituted methylene group, an oxygen atom, a sulfur atom, or a monosubstituted amino group, to form a ring; and
here, in a case where Y₁ to Y₃ represent N-R₂, C-R₃R₄, or Si-R₅R₆, R₂ to R₆ may be bonded to adjacent Q₁ to Q₃ via a linking group such as a single bond, a substituted or unsubstituted methylene group, an oxygen atom, a sulfur atom, or a monosubstituted amino group, to form a ring.

7. The organic electroluminescent element according to claim 6, wherein the compound represented by the foregoing general formula (2) or (3) is a compound represented by any one of the following general formulas (4) to (7): 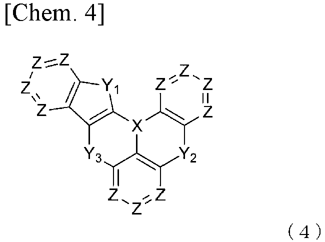 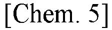 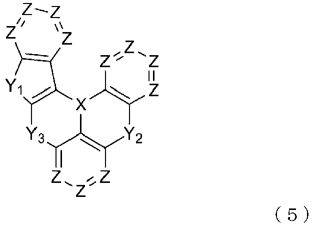 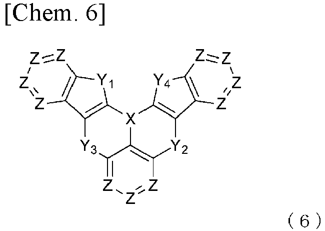 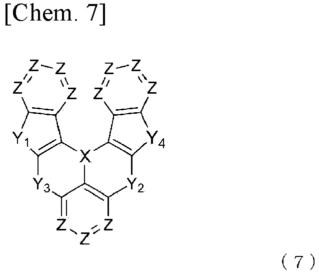
in the general formulas (4) to (7), X, Y₁, Y₂, and Y₃ have the same definitions as those of the foregoing general formulas (2) and (3);
Y₄ represents any one selected from N-R₂, C-R₃R₄, O, S, Se, and Si-R₅R₆, R₂ to R₆ have the same definitions as those of the foregoing general formulas (2) and (3);
Z's may be the same as or different from each other, and each represents CR₇ or N;
R₇' s may be the same as or different from each other, and each represents a hydrogen atom, a deuterium atom, a halogen group, a cyano group, a nitro group, a linear or branched alkyl group having a carbon number of 1 to 6 which may have a substituent, a cycloalkyl group having a carbon number of 5 to 10 which may have a substituent, a linear or branched alkyloxy group having a carbon number of 1 to 6 which may have a substituent, a linear or branched alkylthioxy group having a carbon number of 1 to 6 which may have a substituent, a linear or branched alkylamine group having a carbon number of 1 to 6 which may have a substituent, a linear or branched alkylsilyl group having a carbon number of 3 to 10 which may have a substituent, a substituted or unsubstituted aromatic hydrocarbon group, a substituted or unsubstituted aromatic heterocyclic group, a substituted or unsubstituted aryloxy group, a substituted or unsubstituted arylthioxy group, a substituted or unsubstituted arylamine group, or a substituted or unsubstituted arylsilyl group; and
R₇ may be bonded to another R₇ or bonded to an adjacent substituent to form an aliphatic or aromatic monocyclic or polycyclic ring, and a carbon atom of the aliphatic or aromatic monocyclic or polycyclic ring can be substituted with one or more heteroatoms selected from N, S and O.
